# EUROPEAN PATENT SPECIFICATION

(11) **EP 0 348 893 B1**
(45) Date of publication and mention of the grant of the patent: **06.12.1995**
(21) Application number: 89111676.6
(22) Date of filing: 27.06.1989
(51) Int. Cl.: G11C 17/00

(54) **High speed non-volatile memory device**
Nichtflüchtige Hochgeschwindigkeitsspeichervorrichtung
Dispositif de mémoire non volatile à haute vitesse

(30) Priority: 27.06.1988 JP 158748/88
(43) Date of publication of application: 03.01.1990
(73) Proprietor: NEC CORPORATION, Minato-ku Tokyo (JP)
(72) Inventor: Kobatake, Hiroyuki, Tokyo (JP)
(74) Representative: Glawe, Delfs, Moll & Partner

(56) References cited:
- EP-A- 0 060 078
- EP-A- 0 078 502
- US-A- 4 264 828
- US-A- 4 340 943
- PATENT ABSTRACTS OF JAPAN, vol. 8, no. 33 (P-254)[1470], 14th February 1984; & JP-A-58 188 394 (RICOH K.K.) 02-11-1983

## Description

This invention relates to a non-volatile memory device and, more particularly, to a discharging circuit for discharging the column lines except for that coupled to the access memory cell.

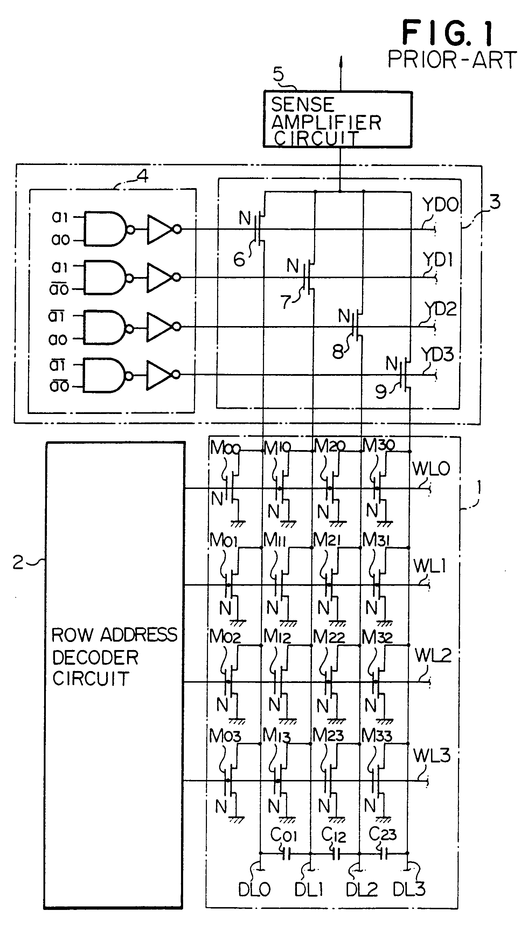

A typical example of the read only memory device is illustrated in Fig. 1 of the drawings and largely comprises a memory cell array 1 having a plurality of memory cells M00 to M33, a row address decoder circuit 2, a column selector circuit 3, a column decoder circuit 4, and a sense amplifier circuit 5. The memory cells M00 to M33 are arranged in rows and columns, and the memory cells M00 to M33 arranged in the rows are respectively coupled to word lines WL0 to WL3. Column lines DL1, DL2 and DL3 are provided in association with the columns of the memory cells, respectively, and output lines of the column selector circuit 4 are labeled with YD0, YD1, YD2 and YD3, respectively. The memory cells in each row line are gated by each of the word lines, and the row address decoder circuit 2 selectively shifts the word lines between an active high voltage level and an inactive low voltage level. The column selector circuit 3 has a plurality of n-channel type field effect transistors 6, 7, 8 and 9 which are associated with the columns of the memory cells, respectively. The column selector circuit 4 has a plurality of series combination circuits each consisting of a NAND gate and an inverter circuit, and one of the NAND gates is responsive to a multiple-bit column address signal and the complementary signal thereof to send an active low voltage level to one of the inverter circuits. The inverter circuit supplied with the active low voltage level allows one of the n-channel type field effect transistors 6 to 9 to turn on, and the n-channel type field effect transistor thus turned on provides a conduction path to the sense amplifier circuit 5.

The memory cells M00 to M33 are formed by n-channel type field effect transistors, respectively, and are grouped by threshold voltage level depending upon data bits stored therein. Namely, the memory cells M00, M11, M12, M23 and M33 respectively memorize data bits of logic "0" level, and, for this reason, are formed by n-channel type field effect transistors each having a relatively low threshold voltage level of, for example, 1 volt. On the other hand, data bits of logic "1" level are stored in the memory cells M01, M02, M03, M10, M13, M20, M21, M22, M30, M31 and M32, respectively, so that the n-channel type field effect transistors thereof have a relatively high threshold voltage level of, for example, 10 volts.

Assuming now that the memory cells M00 and M10 are successively accessed, the row and column address signals firstly cause the row address decoder circuit 2 and the column selector circuit 4 to produce the active high voltage levels applied to the word line WL0 and the output line YD0 coupled to the n-channel type field effect transistor 6. The n-channel type field effect transistor 6 turns on to provide the conduction path between the sense amplifier circuit 5 and the column line DL0, so that the column line DL0 is precharged by the sense amplifier circuit 5 to a high voltage level of, for example, 1.5 volt. Since the n-channel type field effect transistor for the memory cell M00 has the relatively low threshold voltage level, the n-channel type field effect transistor turns on to provide a conduction path from the column line DL0 to the ground node. This results in that the precharged column line DL0 is slightly discharged to a voltage level of, for example, 1.4 volt, and the sense amplifier circuit 5 decides that the data bit read out from the memory cell M00 is logic "0" level.

Next, the column address signal is changed for access to the memory cell M10 at time t1, and, accordingly, the output line YD0 is recovered to the inactive low voltage level, however, the output line YD1 goes up to the active high voltage level. The n-channel type field effect transistor 6 turns off with the inactive low voltage level, and, accordingly, the conduction path between the sense amplifier circuit 5 and the column line DL0 is blocked by the n-channel type field effect transistor 6. On the other hand, the n-channel type field effect transistor 7 turns on to provide a conduction path between the sense amplifier circuit 5 and the column line DL1, thereby allowing the column line DL1 to be precharged by the sense amplifier circuit 5. The word line WL0 remains in the active high voltage level, so that the column line DL0 continues to be coupled to the ground node, and is discharged to the ground voltage level. As the memory cell M10 is formed by the n-channel type field effect transistor with the relatively high threshold voltage level, the n-channel type field effect transistor keeps off, and, for this reason, the column line DL1 is increased in voltage level toward the high voltage level. If the column line DL1 reaches the high voltage level at time t2, the sense amplifier circuit 5 is activated to increase a small differential voltage level between the column line DL1 and the reference node therein (not shown), thereby deciding that the memory cell M10 memorizes the data bit of logic "1" level. This results in that the output signal of the high voltage level is delivered to the outside thereof.

However, a problem is encountered in the prior art read only memory device in that a relatively long time period is consumed for deciding the logic level of the accessed data bit. This is because of the fact that coupling capacitances C01, C12 and C23 are applied to the adjacent two column lines DL0 and DL1, DL1 and DL2, and DL2 and DL3. Namely, the column line DL1 is affected by the fluctuation in voltage level on the adjacent column line DL0 through the coupling capacitance C01, and, for this reason, the column line DL1 can not be fully charged up to the high voltage level until the column line DL0 reaches the ground level. In other words, the column line DL0 is kept in a voltage level slightly lower than the high voltage level until time t3, and goes up to the high voltage level. If there was no coupling capacitance C01, the column line would reach the high voltage level at time t4, and, for this reason, the time period tc between times t4 and t2 is wasted due to the coupling capacitance C01 between the column lines DL0 and DL1.

The smaller the gap between the adjacent column line, the larger coupling capacitance, so that the problem is serious in a semiconductor memory device increased in the number of memory cells.

A non-volatile memory device according to the preamble of claim 1 is disclosed in JP-A-58188394.

EP-A-0060078 discloses a non-volatile memory having plurality of bit line groups, column address selectors for selecting one of the bit line groups and a second selector for selecting a bit line from the selected bit line group.

It is an object of the invention to provide a read only memory device which is improved in reading-out speed.

It is another object of the invention to provide a read only memory device which is free from coupling capacitance between adjacent column lines.

These objects are achieved by a non-volatile memory device as defined in claim 1; claim 2 is related to a development of the invention.

The features and advantages of a non-volatile memory device according to the present invention will be more clearly understood from the following description taken in conjunction with the accompanying drawings in which:
Fig. 1 is a circuit diagram showing the arrangement of a prior art read only memory device;

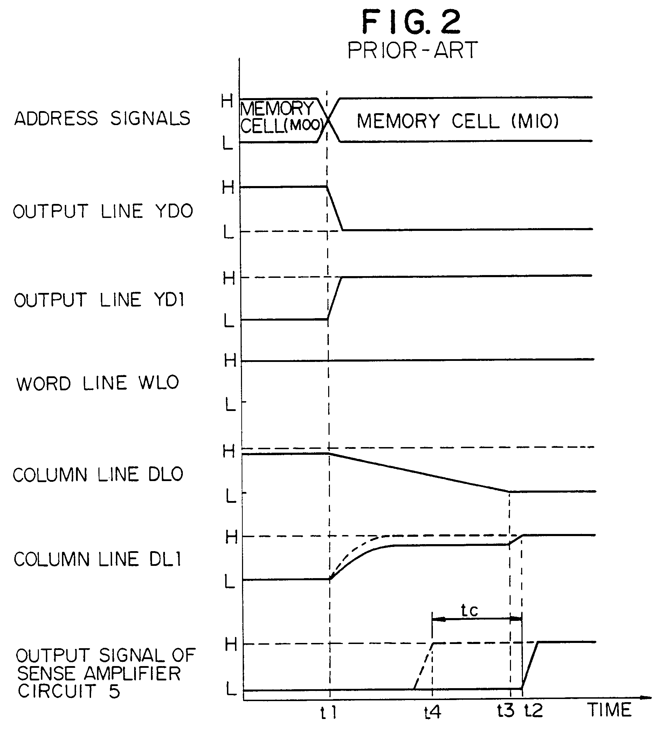

Fig. 2 is a diagram showing the waveforms of essential signals which appear in the prior art read only memory device;
Fig. 3 is a circuit diagram showing the arrangement of another read only memory device;
Fig. 4 is a circuit diagram showing the waveforms of essential signals which appear in the read only memory device shown in Fig. 3;
Fig. 5 is a diagram showing the arrangement of another read only memory device;
Fig. 6 is a circuit diagram showing the arrangement of a read only memory device embodying the present invention;
Fig. 7 is a circuit diagram showing the arrangement of still another read only memory device embodying the present invention;
Fig. 8 is a diagram showing another read only memory cell alternatively used in the read only memory devices shown in Figs. 3, 5, 6 and 7; and
Fig. 9 is a diagram showing an electrically erasable read only memory cell capable of being used for formation of the memory cell arrays shown in Figs. 3, 5, 6 and 7.

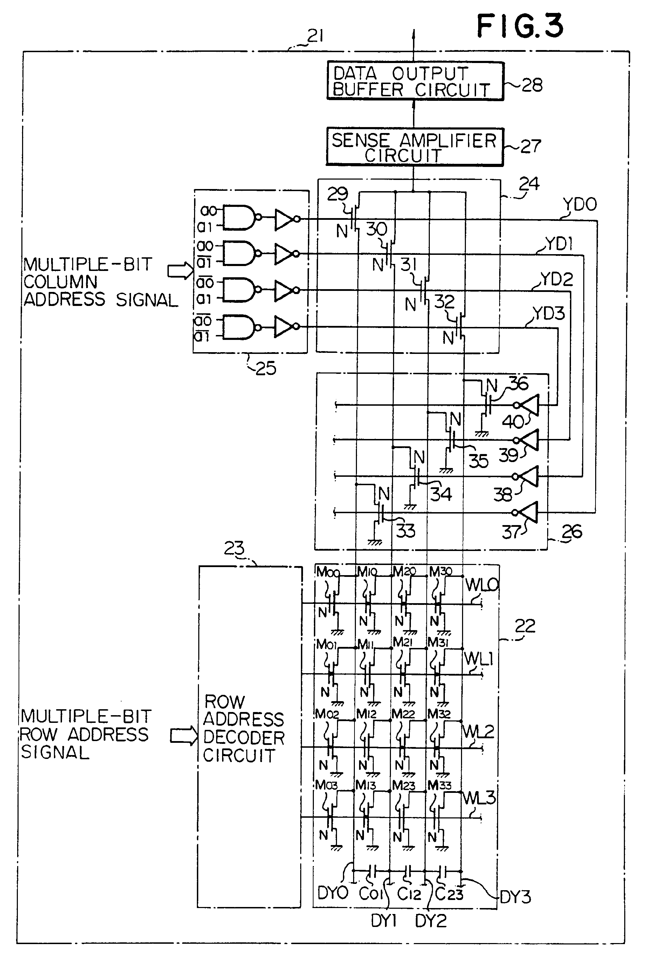

Referring first to Fig. 3 of the drawings, a read only memory device is fabricated on a semiconductor substrate 21 and largely comprises a memory cell array 22 coupled to column lines DYO, DY1, DY2, and DY3, a row address decoder circuit 23 coupled to the memory cell array 22 through word lines WL0, WL1, WL2 and WL3, a column selector circuit 24, a column address decoder circuit 25 coupled to the column selector circuit 24 through column selecting lines YD0, YD1, YD2 and YD3, a discharging facility 26 provided between the memory cell array 22 and the column selector circuit 24 and coupled to the column selecting lines YD0 to YD3, a sense amplifier circuit 27, and a data output buffer circuit 28.

The memory cell array 22 has a plurality of read only memory cells M00 to M33 arranged in rows and columns, and the read only memory cells M00 to M33 are respectively formed by n-channel type field effect transistors. The n-channel type field effect transistors have respective threshold voltage level of either low or high level, and the low and high threshold voltage levels are about 1.0 volt and about 10.0 volts, respectively. In the memory cell array 22, the n-channel type field effect transistors for the memory cells M00, M11, M12, M23 and M33 are of the low threshold level, however, the other n-channel type field effect transistors have the high threshold voltage level. The n-channel type field effect transistors M00 to M33 of the columns are respectively coupled between the column lines DY0 to DY3 and a constant voltage source or a ground node, and the word lines WL0 to WL3 are shared by the n-channel type field effect transistors M00 to M33 of the rows, respectively. Although only sixteen memory cells are illustrated in Fig. 3, a large number of the memory cells are incorporated in the read only memory device, and, for this reason, a substantial amount of capacitance C01, C12 or C23 is coupled between the adjacent two column lines.

The row address decoder circuit 23 is well known by a person skilled in the art, so that no detailed description is incorporated for the sake of simplicity. A multiple-bit row address signal is supplied to the row address decoder circuit 23, and the row address decoder circuit 23 selectively shifts the word lines depending upon the row address signal. If one of the word lines WL0 is by way of example selected by the row address decoder circuit 23 and goes up to the active high voltage level, the memory cells M00, M10, M20 and M30 are activated to allow data bits stored therein to be read out to the column lines DL0 to DL3 in the form of voltage level. However, the non-selected word lines remain in the inactive low voltage level, and no data bit is read out from the other memory cells.

The column selector circuit 24 is provided with a plurality of n-channel type field effect transistors 29, 30, 31 and 32 coupled in parallel to the column lines DY0 to Dy3. The n-channel type field effect transistors 29 to 32 are gated by the column selecting lines YD0 to YD3, and one of the n-channel type field effect transistors 29 to 32 turns on with the active high voltage level to provide a conduction path between one of the column lines and the sense amplifier circuit 27.

The column address decoder circuit 25 comprises a plurality of series combination circuits each having a NAND gate and an inverter circuit, and is supplied with a multiple-bit column address signal. The address bits of the column address signal and the complementary bits thereof are selectively supplied to the NAND gates, and one of the NAND gates produces the active low voltage level depending upon the bit string of the column address signal. The active low voltage level is inverted at the associated inverter circuit to provide the active high voltage level to the column selecting line. Thus, one of the column selecting lines is shifted to the active high voltage level depending upon the bit string of the column address signal, and, accordingly, associated one of the n-channel type field effect transistors turns on to provide the conduction path for propagating the data bit in the form of voltage level.

The discharging circuit 26 has a plurality of n-channel type field effect transistors 33, 34, 35 and 36 which are coupled in parallel between the column lines DY0 to DY3 and the ground node. Inverter circuits 37, 38, 39 and 40 are provided in association with the n-channel type field effect transistors 33 to 36. The column selecting lines YD0 to YD3 are further coupled to the inverter circuit 37 to 40 for selectively gating the n-channel type field effect transistors 33 to 36. Both of the column selector circuit 24 and the discharging circuit 26 are formed by the n-channel type field effect transistors, so that the inverter circuit propagating the active high voltage level causes the associated inverter circuit to supply the n-channel type field effect transistor of the discharging circuit 26 with the inactive low voltage level. However, the other column selecting lines remaining in the inactive low voltage level cause the associated inverter circuits to supply the inverter circuits with the active high voltage levels. Thus, the n-channel type field effect transistors 33 to 36 of the discharging circuit 26 are complementarily shifted between the on-states and the off-states with respect to the n-channel type field effect transistors 29 to 32 of the column selector circuit 24.

The sense amplifier circuit 27 is operative to charge up one of the column lines through the column selector circuit 24, and amplifies a small difference in voltage level between the column line propagating a data bit and a reference node (not shown).

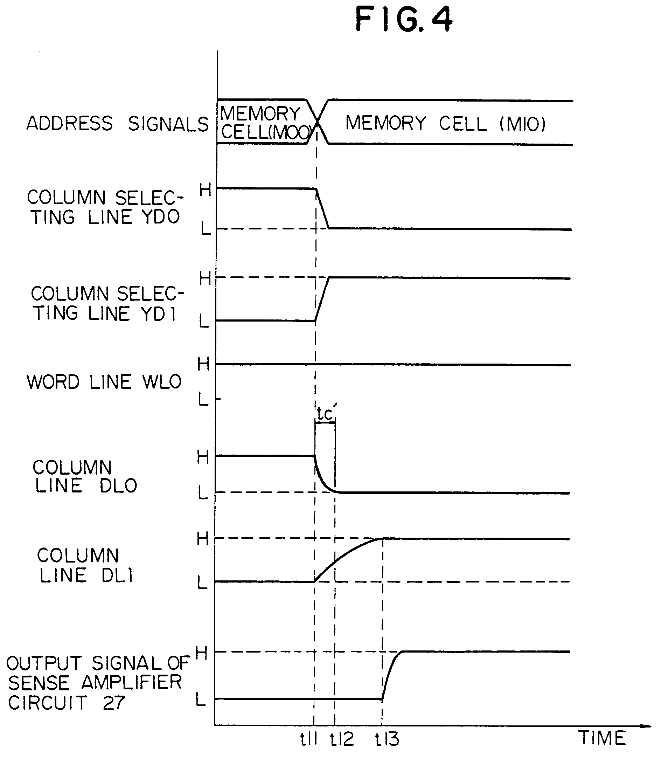

Description is hereinbelow made for the operation of the read only memory device with reference to Fig. 4 on the assumption that the memory cell M00 and, thereafter, the memory cell M10 are successively accessed for reading out the data bits stored therein. With the column address signal, the column address decoder circuit 25 shifts the column selecting line YD0 to the active high voltage level, leaving the other column selecting lines YD1 to YD3 in the inactive low voltage levels. The n-channel type field effect transistor 29 turns on to allow the sense amplifier circuit 27 to charge up the column line DY0, so that the column line DY0 is increased in voltage level toward the high voltage level of, for example, about 1.5 volt. The active high voltage level is inverted by the inverter circuit 37, and the n-channel type field effect transistor 33 remains in the off-state with the low voltage level from the inverter circuit 37. On the other hand, the column selecting lines YD1 to YD3 remain in the inactive low voltage level, and, for this reason, no conduction path is established for the other n-channel type field effect transistors 30 to 32. The inactive low voltage levels on the respective column selecting lines YD1 to YD3 are inverted to the active high voltage levels by the inverter circuits 38 to 40, so that the n-channel type field effect transistors turn on to provide conduction paths between the column lines DY1 to DY3 and the ground node. Since the non-selected column lines DY1 to DY3 are thus grounded through the discharging circuit 26, no high voltage is left on the non-selected column lines.

The row address decoder circuit 23 is supplied with the row address signal and produces the active high voltage level which is applied to the word line WL0. Since the n-channel type field effect transistor for the memory cell M00 has the relatively low threshold voltage level, the n-channel type field effect transistor turns on to provide a conduction path from the column line DL0 to the ground node. This results in that the column line DL0 is slightly discharged to a voltage level of, for example, 1.4 volt, and the sense amplifier circuit 5 decides that the data bit read out from the memory cell M00 is logic "0" level. Though not shown in the drawings, the n-channel type field effect transistors 31 and 32 remain in the off-states, and the n-channel type field effect transistors 35 and 36 are turned on throughout the reading out operations.

Next, the column address signal is changed for access to the memory cell M10 at time t11, and, accordingly, the column selecting line YD0 is recovered to the inactive low voltage level, however, the column selecting line YD1 goes up to the active high voltage level. The n-channel type field effect transistor 29 turns off with the inactive low voltage level, and, accordingly, the conduction path between the sense amplifier circuit 27 and the column line DL0 is blocked by the n-channel type field effect transistor 29. The inactive low voltage level on the column selecting line YD0 is inverted to the active high voltage level by the inverter circuit 37, and the active high voltage level allows the n-channel type field effect transistor 33 to turn on. Then, the column line DY0 is rapidly discharged and, accordingly, reaches the ground voltage level at time t12. The time period tc′ between times t11 and t12 is surely reduced by virtue of the discharging circuit 26.

On the other hand, the n-channel type field effect transistor 30 turns on to provide a conduction path between the sense amplifier circuit 27 and the column line DL1 with the active high voltage level supplied from the column address decoder circuit 25, thereby allowing the column line DL1 to be precharged by the sense amplifier circuit 27. The inverter circuit 38 produces the inactive low voltage level, so that the n-channel type field effect transistor 34 turns off to block the conduction path between the column line DY1 and the ground node. The word line WL0 remains in the active high voltage level, so that the column line DL0 continues to be connected to the ground node. Since the memory cell M10 is formed by the n-channel type field effect transistor with the relatively high threshold voltage level, the n-channel type field effect transistor keeps off, and, for this reason, the column line DL1 is rapidly increased toward the high voltage level, because the column line DY0 has been already discharged to the ground level. If the column line DL1 reaches the high voltage level at time 13, the sense amplifier circuit 27 decides that the data bit read out from the memory cell M10 is logic "1" level, and shifts the output signal thereof to the high voltage level.

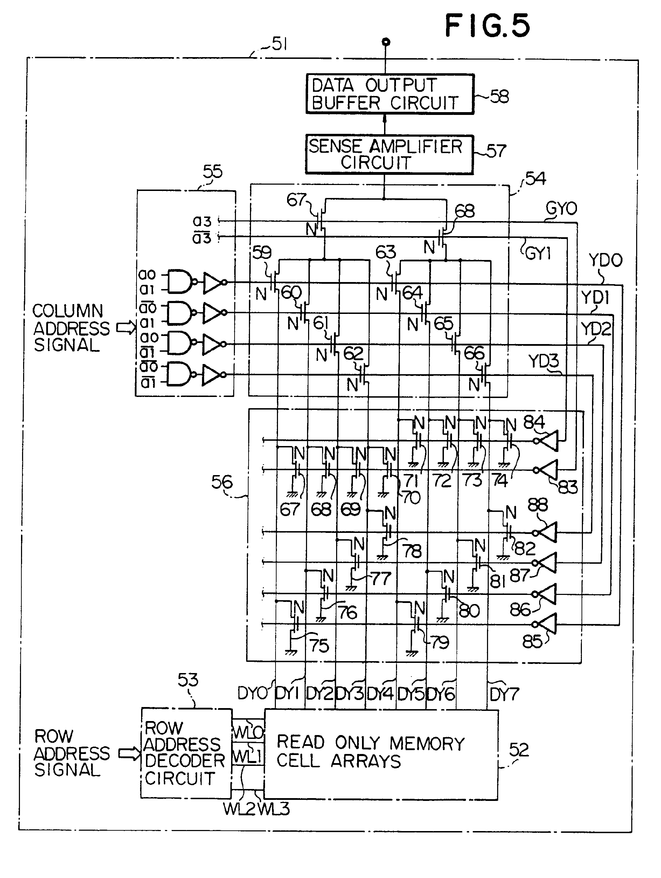

Turning to Fig. 5, another read only memory device is fabricated on a semiconductor substrate 51 and largely comprises two read only memory cell arrays 52 coupled to column lines DY0, DY1, DY2 and DY3, and DY4, DY5 DY6 and DY7, respectively, a row address decoder circuit 53 coupled to the memory cell array 52 through word lines WL0, WL1, WL2 and WL3, a column selector circuit 54, a column address decoder circuit 55 coupled to the column selector circuit 54 through column selecting lines YD0, YD1, YD2 and YD3 as cell as group selecting lines GY0 and GY1, a discharging facility 56 provided between the memory cell array 52 and the column selector circuit 54 and coupled to the column selecting lines YD0 to YD7, a sense amplifier circuit 57, and a data output buffer circuit 58.

The word lines WL0 to WL3 are shared by the two read only memory cell arrays 52, and the column selector circuit 54 is formed in a two-stage configuration. Namely, two groups of n-channel type field effect transistors 59, 60, 61, 62, 63, 64, 65 and 66 form in combination the first stage of the column selector circuit 54, and two n-channel type field effect transistors 67 and 68 constitute the second stage of the column selector circuit 54. The column decoder circuit 55 selectively shifts not only the column selecting lines YD0 to YD3 but also the group selecting lines GY0 and GY1. When one of the column selecting lines YD0 to YD3 goes up to the high voltage level, one of the n-channel type field effect transistors 59 to 62 turns on, and another n-channel type field effect transistor is selected from the second group of the n-channel type field effect transistors 63 to 66. For this reason, two conduction paths are established in the first stage of the column selector circuit 54. The column decoder circuit 55 further shifts one of the group selecting lines GY0 and GY1, so that one of the n-channel type field effect transistors 67 and 68 turns on to provide a conduction path between the sense amplifier circuit 57 and the first stage. Thus, only one series of the conduction paths takes place through the column selector circuit 54, and, accordingly, one of the column lines DY0 to DY7 is charged up by the sense amplifier circuit 57 for reading out a data bit from the accessed memory cell.

Since the column selector circuit 54 is of the two stage arrangement, the discharging circuit 56 is also formed with two groups of discharging transistors respectively formed by n-channel type field effect transistors 67 to 82. The n-channel type field effect transistors 67 to 74 of the first stage are further divided into two sub-groups, and the first and second sub-groups are associated with two column line groups DY0 to DY3 and DY4 to DY7. The n-channel type field effect transistors of the first sub-group are gated by the complementary signal produced by an inverter circuit 83, and are complementarily shifted between on-states and off-states with respect to the n-channel type field effect transistor 67. Similarly, the n-channel type field effect transistors 71 to 74 of the second sub-group are simultaneously gated by an inverter circuit 84, and are established into the opposite states with respect to the n-channel type field effect transistor 68. Thus, one of the column line groups is directly conducted to the ground node. The n-channel type field effect transistors 75 to 82 of the second group are also divided into two sub-groups, and are gated by inverter circuits 85 to 88 which are coupled to the column selecting lines YD0 to YD3, respectively. This arrangement results in that two of the n-channel type field effect transistors 75 to 82 are complementary shifted between the on-states and the off-states with respect to the associated n-channel type field effect transistors 59 to 66, so that two column lines are blocked from the ground node by the two n-channel type field effect transistors of the second group. However, one of the two column lines is conducted to the ground node through one of the sub-groups of the n-channel type field effect transistors 67 to 74. For this reason, only one column line is isolated from the ground node and propagates the data bit read out from the accessed memory cell in the form of voltage level.

The other circuit arrangements and the behaviors thereof are similar to those of the read only memory device shown in Fig. 3, and, for this reason, no further description is hereinbelow incorporated.

### First embodiment

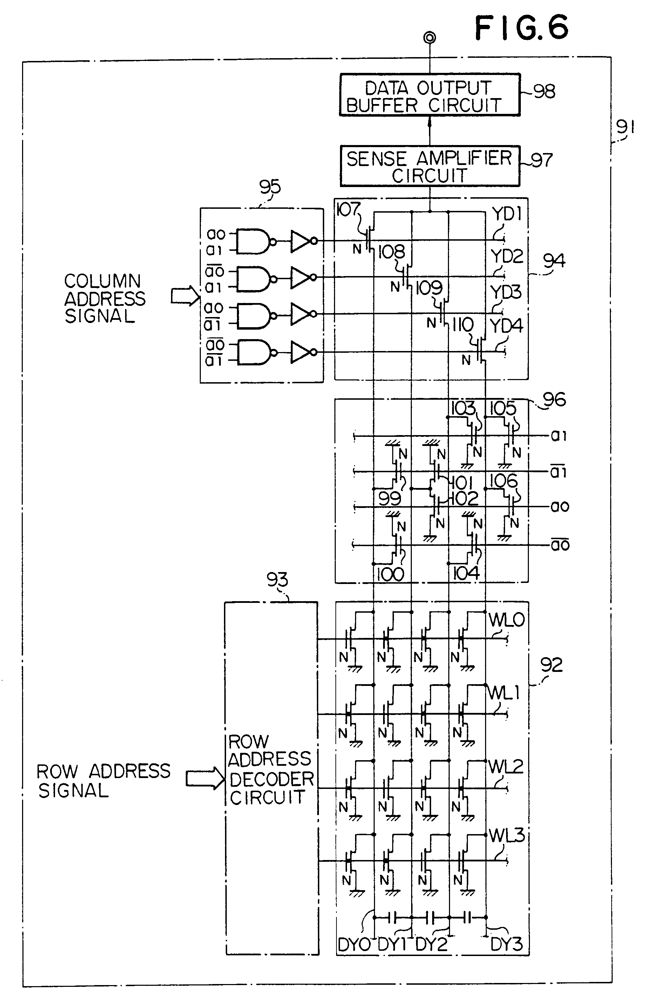

Turning to Fig. 6, another read only memory device is fabricated on a semiconductor substrate 91 and largely comprises a read only memory cell array 92 coupled to column lines DY0, DY1, DY2 and DY3, respectively, a row address decoder circuit 93 coupled to the memory cell array 92 through word lines WL0, WL1, WL2 and WL3, a column selector circuit 94, a column address decoder circuit 95 coupled to the column selector circuit 94 through column selecting lines YD0, YD1, YD2 and YD3, a discharging facility 96 provided between the memory cell array 92 and the column selector circuit 94 and supplied with the row address bits a0 and a1 and the complementary bits thereof, a sense amplifier circuit 97, and a data output buffer circuit 98.

The discharging circuits 96 comprises n-channel type field effect transistors 99 to 105 grouped by two, and every two n-channel type field effect transistors are coupled in parallel to every column lines DY0 to DY3. The row address bits a0 and a1 and the complementary bits thereof are selectively supplied to the n-channel type field effect transistors 99 to 106 in such a manner as to be complementarily shifted between on-states and off-states with respect to associated n-channel type field effect transistors 107 to 110 of the column selector circuit 94. For example, if both of the row address bits a0 and a1 are logic "1" level, the n-channel type field effect transistor 107 turns on to charge up the column line DY0, and the row address bits of logic "1" level allows the n-channel type field effect transistors 102, 103, 105 and 106 to turn on to discharge the column lines DY1 to DY3. Thus, the n-channel type field effect transistors 99 to 106 are complementarily shifted with respect to the n-channel type field effect transistors 107 to 110 for discharging the column lines except for that coupled to the accessed memory cell.

The other component circuits and the behaviors thereof are similar to those shown in Fig. 3, so that detailed description is omitted for the sake of simplicity.

### Second embodiment

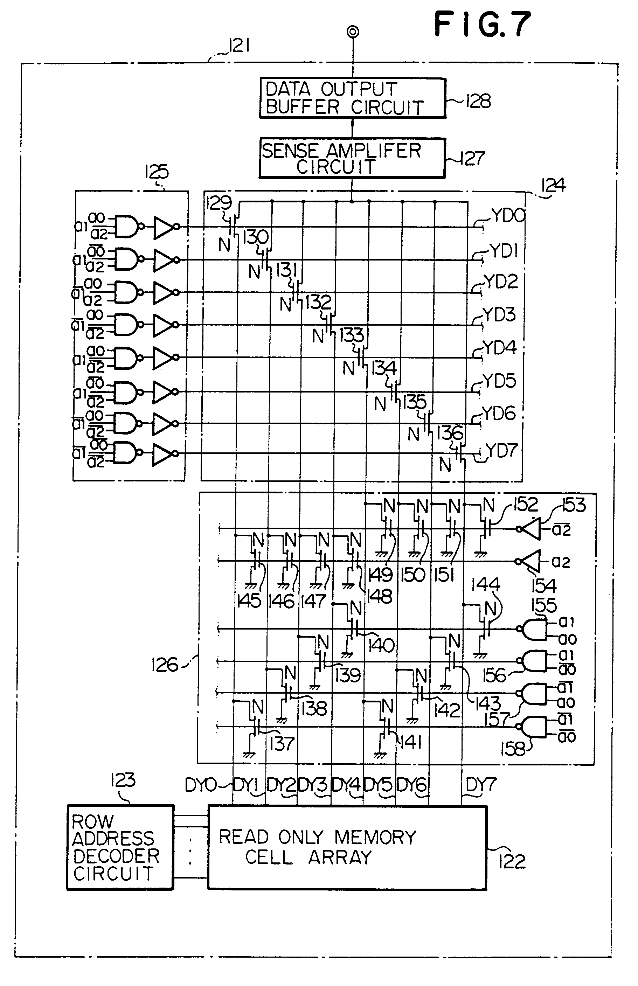

Turning to Fig. 7, another read only memory device is fabricated on a semiconductor substrate 121 and largely comprises a read only memory cell array 122 coupled to column lines DY0, DY1, DY2 DY3, DY4, DY5 DY6 and DY7, respectively, a row address decoder circuit 123 coupled to the memory cell array 122 through word lines, a column selector circuit 124, a column address decoder circuit 125 coupled to the column selector circuit 124 through column selecting lines YD0, YD1, YD2, YD3, YD4, YD5, YD6 and YD7, a discharging facility 126 provided between the memory cell array 122 and the column selector circuit 124, a sense amplifier circuit 127, and a data output buffer circuit 128.

The column selector circuit 124 has a plurality of n-channel type field effect transistors 129 to 136 selectively gated by the column selecting lines YD0 to YD7, and the discharging circuit 126 is formed with two groups of discharging transistors respectively formed by n-channel type field effect transistors 137 to 152. The n-channel type field effect transistors 145 to 152 of the first stage are further divided into two sub-groups, and the first and second sub-groups are associated with two column line groups DY0 to DY3 and DY4 to DY7. The n-channel type field effect transistors of the first sub-group are gated by the row address bit a2 and the complementary bit supplied from inverter circuits 153 and 154, and are complementarily shifted between on-states and off-states. Thus, one of the column line groups is directly conducted to the ground node.

The n-channel type field effect transistors 137 to 144 of the second group are also divided into two sub-groups, and are gated by NAND gates 155 to 158 which are selectively supplied with the row address bits aO and al and the complementary bits thereof. One of the NAND gates 155 to 158 produces the inactive low voltage level, so that only two n-channel type field effect transistors turn off to isolate the column lines coupled to the memory cells specified by the row address signal. Thus, only one current path is established from the sense amplifier circuit 127 to one of the column lines DY0 to DY7 which is isolated from the ground node, however, the other column lines are connected to the ground node through two-stage discharging circuit 126.

The other circuit arrangements and the behaviors thereof are similar to those of the read only memory device shown in Fig. 3, and, for this reason, no further description is hereinbelow incorporated. The discharging circuit 126 shown in Fig. 7 has the two-stage arrangement, and, for this reason, the signal lines passing therethrough are decreased in number in comparison with a single stage arrangement.

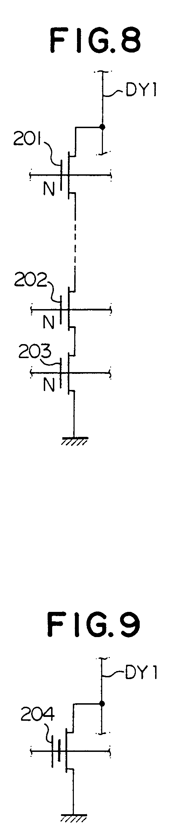

Modifications are possible, for example, each of the memory cells incorporated in the above mentioned read only memory devices is formed of a single n-channel type enhancement-mode field effect transistor, however, the memory cell may be implemented by a series of n-channel type enhancement-mode field effect transistors 201 to 203 as shown in Fig. 8. The series of the n-channel type field effect transistors 201 to 203 achieve a NAND operation. Moreover, the memory cell array may be formed by electrically erasable read only memory cells, and each of the electrically erasable read only memory cell can be implemented by a floating gate type MOS field effect transistor 204 shown in Fig. 9.

## Claims

1. A non-volatile memory device fabricated on a semiconductor substrate, comprising:
a) a plurality of non-volatile memory cells arranged in rows and columns and coupled in parallel to a constant voltage source, said non-volatile memory cells respectively having threshold voltage levels of either high or low level depending upon data bits memorized therein,
b) a plurality of word lines (WL0 - WL3) coupled to the rows of said non-volatile memory cells, respectively, and selectively driven to an active level for simultanously reading out the data bits from the memory cells of one of said rows,
c) a row address decoder circuit (93, 123) supplied with a row address signal and selectively driving one of said word lines to said active level,
d) a plurality of column lines (DY0 - DY3; DY0 - DY7) coupled to said non-volatile memory cells of the columns for propagating the data bits read out form said memory cells in the form of voltage level,
e) a column selector circuit (94, 124) coupled to said column lines and activated so as to provide a conduction path for one of said column lines,
f) a column address decoder circuit (95, 125) supplied with a column address signal for causing said column selector circuit to select one of said plurality of column lines,
g) a sense amplifier circuit (97, 127) for receiving the data bit in the form of voltage level and to decide the logic level of the data bit received,
h) a discharging circuit (96, 126) coupled between said column lines and said constant voltage source,
**characterized** in that said sense amplifier is operative to charge said one of said column lines through the column selector circuit and
that said discharging circuit (96) comprises a plurality of switching transistors selectively coupled between said plurality of column lines and said constant voltage source and responsive to said column address signal for discharging at least the column lines adjacent to said one of said column lines.

2. A non-volatile memory device as claimed in claim 1,
**characterized**
in that said plurality of column lines is divided into a plurality of column line groups, that an auxiliary column address decoder unit (153 - 158) is provided responsive to said column address signal for producing a column address decoded signal having first signals and second signals, and in that said discharging circuit (126) comprises a plurality of first transistor groups (145 - 148; 149 - 152) respectively associated with said plurality of column line groups and responsive to said first signals so as to select one of said plurality of column line groups, and a plurality of second transistor groups (137 - 140; 141 - 144) respectively associated with said plurality of column lines and each having a plurality of switching transistors gated with said second signals for coupling column lines selected from said one of said plurality of column line groups and adjacent to said one of said column lines with said constant voltage source.

## Patentansprüche

1. Nichtflüchtige Speichervorrichtung, die auf einem Halbleitersubstrat gefertigt ist, mit:
a) einer Anzahl nichtflüchtiger Speicherzellen, die in Reihen und Spalten angeordnet und parallel mit einer Konstantspannungsquelle verbunden sind, wobei die nichtflüchtigen Speicherzellen jeweils Schwellspannungspegel von entweder hohem oder niedrigem Pegel aufweisen, abhängig von den darin gespeicherten Datenbits,
b) einer Anzahl von Wortleitungen (WL0-WL3), die jeweils mit den Reihen der nichtflüchtigen Speicherzellen verbunden sind und selektiv auf einem aktiven Pegel betrieben werden, zum gleichzeitigen Auslesen der Datenbits aus den Speicherzellen einer der Reihen,
c) einer Reihenadress-Dekoderschaltung (93, 123), die mit einem Reihenadress-Signal versorgt wird und selektiv eine der Wortleitungen auf dem aktiven Pegel betreibt,
d) einer Anzahl von Spaltenleitungen (DY0-DY3; DY0-DY7), die mit den nichtflüchtigen Speicherzellen der Spalten verbunden sind, zum Weiterleiten der aus den Speicherzellen ausgelesenen Datenbits in Form eines Spannungspegels,
e) einer Spaltenauswahlschaltung (94, 124), die mit den Spaltenleitungen verbunden ist und derart aktiviert wird, daß sie einen Leitungsweg für eine aus der Spaltenleitungen schafft,
f) einer Spaltenadress-Dekoderschaltung (95, 125), die mit dem Spaltenadress-Signal versorgt wird, um die Spaltenauswahlschaltung zu veranlassen, eine der Anzahl von Spaltenleitungen auszuwählen
g) einer Leseverstärkerschaltung (97, 127) zum Empfang des Datenbits in Form eines Spannungspegels und zur Beurteilung des Logikpegels des empfangenen Datenbits,
h) einer Entladungsschaltung (96, 126), die zwischen die Spaltenleitungen und die Konstantspannungsquelle geschaltet ist, dadurch **gekennzeichnet,**
daß der Leseverstärker operativ ist, um die eine der Spaltenleitungen durch die Spaltenauswahlschaltung zu laden, und daß die Entladungsschaltung (96) eine Anzahl von Schalttransistoren aufweist, die selektiv zwischen der Anzahl von Spaltenleitungen und der Konstantspannungsquelle geschaltet sind und auf das Spaltenadress-Signal ansprechen, zum Entladen mindestens der Spaltenleitung, die an die eine der Spaltenleitungen angegrenzt.

2. Nichtflüchtige Speichervorrichtung nach Anspruch 1,
dadurch **gekennzeichnet,** daß die Anzahl der Spaltenleitungen in eine Anzahl von Spaltenleitungsgruppen unterteilt ist, daß eine Hilfsspaltenadress-Dekodereinheit (153-158) vorgesehen ist, die abhängig ist von dem Spaltenadressignal, zum Erzeugen eines dekodierten Spaltenadressignals, das erste Signale und zweite Signale aufweist, und daß die Entladungsschaltung (126) eine Anzahl erster Transistorgruppen (145-148; 149-152) aufweist, die jeweils der Anzahl von Spaltenleitungsgruppen zugeordnet sind und auf die ersten Signale derart ansprechen, daß sie eine der Anzahl von Spaltenleitungsgruppen auswählen, und mit einer Anzahl zweiter Transistorgruppen (137-140, 141-144), die jeweils der Anzahl der Spaltenleitungen zugeordnet sind und eine Anzahl von Schalttransistoren aufweist, die durch die zweiten Signale gesteuert werden, zum Verbinden von Spaltenleitungen, die aus der einen der Anzahl der Spaltenleitungsgruppen ausgewählt sind und an die eine der Spaltenleitungen angrenzt, mit der Konstantspannungsquelle.

## Revendications

1. Dispositif de mémoire non volatile réalisé sur un substrat semi-conducteur, comprenant:
a) un ensemble de cellules mémoires non volatiles agencées en lignes et en colonnes et couplées en parallèle à une source de tension constante, lesdites cellules mémoires non volatiles ayant respectivement des niveaux de tension de seuil hauts ou bas selon les bits de données qu'elles mémorisent,
b) un ensemble de lignes de mots (WL0 - WL3) respectivement couplées aux lignes desdites cellules mémoires non volatiles, et sélectivement portées à un niveau actif pour lire simultanément les bits de données dans les cellules mémoires desdites lignes,
c) un circuit décodeur d'adresse de ligne (93, 123) recevant un signal d'adresse de ligne et faisant passer sélectivement l'une desdites lignes de mots audit niveau actif,
d) un ensemble de conducteurs de colonnes (DY0 - DY3; DY0 - DY7) couplés auxdites cellules mémoires non volatiles des colonnes pour provoquer la propagation des bits de données lus dans lesdites cellules mémoires sous la forme d'un niveau de tension,
e) un circuit sélecteur de colonne (94, 124) couplé auxdits conducteurs de colonnes et activé de façon à établir un trajet de conduction pour l'un desdits conducteurs de colonnes,
f) un circuit décodeur d'adresse de colonne (95, 125) recevant un signal d'adresse de colonne pour provoquer la sélection par ledit circuit sélecteur de colonne de l'un desdits conducteurs de colonnes,
g) un circuit amplificateur de lecture (97, 127) pour recevoir le bit de donnée sous la forme d'un niveau de tension et pour déterminer le niveau logique du bit de donnée reçu,
h) un circuit de décharge (96, 126) couplé entre lesdits conducteurs de colonnes et ladite source de tension constante,
caractérisé en ce que ledit amplificateur de lecture a pour fonction de charger ledit conducteur de colonne par l'intermédiaire du circuit sélecteur de colonnes et
en ce que ledit circuit de décharge (96) comprend un ensemble de transistors de commutation sélectivement couplés entre ledit ensemble de conducteurs de colonnes et ladite source de tension constante et sensible audit signal d'adresse de colonne pour décharger au moins les conducteurs de colonne adjacents audit conducteur de colonne.

2. Dispositif de mémoire non volatile selon la revendication 1,
caractérisé
en ce que ledit ensemble de conducteurs de colonnes est divisé en un ensemble de groupes de conducteurs de colonnes, en ce qu'une unité de décodage d'adresse de colonne auxiliaire (153 - 158) est prévue, cette unité répondant audit signal d'adresse de colonne pour produire un signal d'adresse de colonne décodé ayant des premiers signaux et des seconds signaux, et en ce que ledit circuit de décharge (126) comprend un ensemble de premiers groupes de transistors (145 - 148; 149 - 152) respectivement associés audit ensemble de groupes de conducteurs de colonnes et sensibles auxdits premiers signaux afin de sélectionner l'un dudit ensemble de groupes de conducteurs de colonnes, et un ensemble de seconds groupes de transistors (137 - 140; 141 - 144) respectivement associés audit ensemble de conducteurs de colonnes et ayant chacun un ensemble de transistors de commutation déclenchés par lesdits seconds signaux pour coupler des conducteurs de colonnes sélectionnés parmi ledit ensemble de groupes de conducteurs de colonnes et adjacents audit premier conducteur des conducteurs de colonnes avec ladite source de tension constante.
